Europäisches Patentamt
European Patent Office
Office européen des brevets

(11) Publication number: **0 291 009 A2**

# EUROPEAN PATENT APPLICATION

(21) Application number: 88107481.9

(51) Int. Cl.[4]: H01L 39/12 , H01L 39/24

(22) Date of filing: 10.05.88

(30) Priority: 15.05.87 US 50824

(43) Date of publication of application: 17.11.88 Bulletin 88/46

(84) Designated Contracting States: DE ES FR GB IT

(71) Applicant: PPG INDUSTRIES, INC.
One PPG Place
Pittsburgh Pennsylvania 15272(US)

(72) Inventor: Yoldas, Bulent Erturk
1605 Jamestown Place
Pittsburgh Pennsylvania 15235(US)

(74) Representative: Sternagel, Hans-Günther, Dr. et al
Patentanwälte Dr. Michael Hann Dr. H.-G. Sternagel Sander Aue 30
D-5060 Bergisch Gladbach 2(DE)

## (54) Formation of superconductive ceramic oxides by chemical polymerization.

(57) A multi-component metal alkoxide sol-gel composition and method for its reaction are disclosed whereby a mixture of metal alkoxides is partially hydrolyzed and condensed, and the resulting composition is further hydrolyzed and condensed to form a metal network which is thermally reacted to produce a mixed metal oxide ceramic with superconducting properties.

EP 0 291 009 A2

# FORMATION OF SUPERCONDUCTIVE CERAMIC OXIDES BY CHEMICAL POLYMERIZATION

## Field of the Invention

The present invention relates generally to the art of superconducting ceramic oxides, and more particularly, to the art of chemical polymerization processes for producing ceramic oxides.

## Background of the Invention

Transition metal alloys such as NbTi, $Nb_3X$ and $V_3X$, wherein X is a non-transition-metal element such as tin, silicon or germanium, having an A15 crystal structure were known to exhibit superconductivity at temperatures of 17 to 23K. Metal oxides such as $LiTi_2O_4$ and $BaPb_{1-x}Bi_xO_3$, wherein x is optimally 0.25, were found to exhibit superconductivity at temperatures of around 13K. A composition of $Ba_xLa_{5-x}Cu_5O_{5(3-y)}$ annealed near 900°C under reducing conditions showed features associated with superconductivity near 30K. This Ba-La-Cu-O system comprised several phases, the superconducting one being identified as $Ba_xLa_{2-x}CuO_{4-y}$, a phase with a tetragonal structure. A single phase composition where x = 0.15 exhibited conductivity at 23K. By substituting strontium for barium in such compositions, superconductivity has been observed at temperatures up to 52K. By substituting yttrium for lanthanum, conductivity has been observed at temperatures of 80K and as high as 95K. The Y-Ba-Cu-O system comprised two phases, a green semiconducting phase and a black superconducting phase identified as $YBa_2Cu_3O_{9-y}$, an oxygen-deficient perovskite wherein y represents the oxygen deficiency and is optimally about 2.1.

This class of compounds may be addressed as $RBa_2Cu_3O_{9-y}$ wherein R may be a transition metal or rare earth ion such as scandium, lanthanum, neodymium, sanarium, europium, gadolinium, dysprosium, trolmium, erbium, ytterbium and lutetium. Such compositions have been reportedly synthesized by conventional ceramic techniques. Metal oxide or carbonate powders of the required metals are thoroughly mixed in appropriate ratios and heated for several hours to allow solid-state reaction. The mixture is then cooled, ground, pelletized and sintered at 900 to 1100°C to yield a single phase composition of the desired proportions. For example, powders of $La_2O_3$, $BaO_2$, CuO, $BaCO_3$, $SrCO_3$, and $CaCO_3$ have been mixed, calcined, pulverized, pelletized and sintered to form such well-known superconducting compositions as $La_{1.85}Sr_{0.15}CuO_{4-y}$, $Y_{1.2}Ba_{0.8}CuO_{4-y}$ and $YBa_2Cu_3O_{9-y}$. Superconductivity depends heavily on the relative proportions of the metals. Further, superconductivity depends critically on the oxygen deficiency factor y which is determined by the temperature and atmosphere in which the powders are sintered, as well as on the cooling rate, and which is extremely difficult to control. In these conventional ceramic oxide forming processes, the heating necessary to attain a homogeneous composition can be detrimental to superconductivity by promoting grain growth and phase separation.

The present invention provides equivalent superconducting ceramic compositions by chemical polymerization processes from organometallic reactants at ambient temperatures. These "sol-gel" processes allow better control of composition stoichiometry, which is critical for superconducting materials, and also allow monitoring of the oxidation state of copper. Sol-gel processes also permit formation of superconductive mixed metal oxide composition precursors which are coatable in a liquid state, formable in a thermoplastic polymeric state, and can be impregnated into a porous matrix. The chemical polymerization process allows for the existence of stable nonequilibrium states, as well as modification of the coordination and valence states of the metal components, by eliminating the high temperature consolidation reactions of conventional ceramic processes. Chemical polymerization methods are generally known in the art, as disclosed in the following references.

U.S. Patent Nos. 4,208,475 and 4,244,986 to Paruso and Yoldas describe a liquid polymer formed from organometallic sodium and aluminum compounds, at least one of which is partially hydrolyzed. The polymer is hydrolyzed, dried to from amorphous sodium Beta-alumina precursor, and then heated to 1200-1550°C. to form a ceramic comprising ion-conductive sodium Beta-alumina which is useful as a solid electrolyte.

U.S. Patent No. 4,271,210 to Yoldas discloses a method of forming an optically clear, porous metal oxide layer having a low refractive index on a glass substrate by dipping the substrate into a clear colloidal solution of metal alkoxide. The low refractive index porous metal oxide layer forms an effective anti-reflective layer.

U.S. Patent Nos. 4,278,632 and 4,346,131 to Yoldas disclose sol-gel compositions comprising silicon and titanium. According to these patents, hydrolytic polycondensation of metal alkoxides produces polymeric species containing alkoxy and hydroxyl pendent and terminal groups. Typical sol-gel compositions contain about 10 to 40 percent by weight organic and hydroxyl components. Heat treatment is carried out at sufficiently high temperature, generally around 500°C., to remove residual organic material.

U.S. Patent No. 4,286,024 to Yoldas discloses a high temperature resistant transparent monolithic member or coating consisting of aluminum and silicon in a ratio of about 2:1 and in reacted oxide form, formed by reacting precursor alkoxides of aluminum and silicon in the presence of water to form a clear solution, gelling the reacted precursors, and drying the gel in the form of a monolithic member or coating on a substrate. The dried material is then heated to evolve all residual hydrogen, carbon and water and to eliminate porosity.

U.S. Patent No. 4,293,594 to Yoldas discloses a method for forming a conductive transparent coating by vaporizing an organic tin halide compound in a carrier gas, heating the substrate to be coated with said vapor to a temperature above the decomposition temperature of said organic tin halide, and contacting said heated substrate with said organic tin halide vapor which breaks down to form a transparent conductive coating.

## Summary of the Invention

The present invention provides a method for making the recently discovered oxide superconductors by chemical polymerization at ambient temperature of metal organic reactants. This method not only provides a more precise control of composition and stoichiometry, but also permits noncompositional structural modifications, including the formation of amorphous states. The intermediate reaction products are highly pliable thermoplastic polymers which can be readily shaped, and in their liquid state can be coated on substrates as thin films for devices or impregnated into porous materials. Thus, the chemical polymerization process provides a means to modify the composition, physical form, electronic and molecular states and micro-structures of these superconductive ceramic oxides.

The present invention provides a sol-gel process for the production of multi-component ceramic oxide compositions having an oxygen deficient perovskite type crystal structure known to exhibit superconducting properties. The present invention involves combining reactants such as hydrolyzable alkoxides of barium, lead, yttrium, bismuth, lanthanum, strontium and copper and the like in an appropriate nonaqueous solvent, acidifying the reaction mixture to dissolve the reactants, and reacting them to form an inorganic oxide polymer network having said metals in the appropriate proportions required for superconducting ceramic oxide compositions. The metal alkoxide compositions provide pliable thermoplastic polymeric materials, as well as clear homogenous solutions which can be coated on glass, metals, ceramics and plastics or impregnated into a porous matrix. Whether in coating, matrix or bulk form, the compositions are ultimately thermally treated to form the desired ceramic oxide. The sol-gel mixed metal alkoxide compositions may also function as a carrier and binder for other desired components. An important feature of the present invention is that the proportion of metal alkoxides can be selected to produce a composition with the required composition, structure and form to exhibit superconducting properties without undergoing the very high temperature sintering which makes control of the oxygen deficiency factor and microstructure difficult in conventional ceramic processes. Significantly, the method of the present invention provides for the formation of thin films of superconductive materials which can be used in devices.

## Description of the Preferred Embodiments

The formation of the oxide networks of superconductive compositions by a room temperature polymerization process can be achieved by utilization of metal-organic compounds, particularly metal-alkoxides of the required elements, e.g. $La(OR)_3$, $Cu(OR)_2$, $Ba(OR)_2$, $Y(OR)_3$ etc. where R is preferably an alkyl group.

A multi-component mixed metal alkoxide composition is prepared in accordance with the present invention in order to provide a composition of mixed metal oxides which can be coated on metal, ceramic, glass and plastics and exhibit superconductivity in ceramic oxide form. The metal alkoxides include alkoxides of the general formula

$M(OR)_z$
wherein M is a metal selected from the group consisting of barium, yttrium, lead, bismuth, lanthanum, strontium and copper and mixtures thereof, z is the valence of M, and R is a low molecular weight alkyl radical, preferably ethyl, propyl or butyl. In addition to barium, yttrium, bismuth, lead, lanthanum, strontium and copper, other transition metal or rare earth alkoxides may be employed to produce mixed metal oxides known to exhibit superconducting properties. The metal alkoxide may include an alkyl or aryl group or be in dimer or higher condensed form so long as hydrolyzable alkoxy groups remain reactive. Other organometallic compounds such as acetates may be used, as well as some amount of inorganic compounds such as nitrates so long as a sufficient proportions of polymerizable species is present.

Forming multi-component oxide compositions such as those reported for superconductivity by polymerization of alkoxides presents several problems. The hydrolytic polycondensation of a mixture of alkoxides results in gross inhomogeneities due to different hydrolysis rates. Inhomogeneities due to the different hydrolysis rates of mixed alkoxides can largely be remedied by two methods. The first is by partial hydrolysis of the alkoxides followed by reaction of the hydroxyl groups with alkoxy groups. The second is by greatly reducing the chemical encounter rates with water. The rate of chemical encounters that result in self-condensation can be greatly reduced by first diluting the alkoxide mixtures in an inert solvent, then introducing water in very small quantities in diluted form or by humidity hydrolysis as follows:

$$aM_1(OR)_{z_1} + bM_2(OR)_{z_2} + cM_3(OR)_{z_3} + d\ H_2O \rightarrow (=M_1\text{-}O\text{-}M_2\text{-}O\text{-}M_3=)_n$$

wherein d is much less than a, b and c, and $M_1$, $M_2$, $M_3$ are metal elements of the superconductive oxide composition having valences $z_1$, $z_2$, $z_3$ respectively. The effectiveness of this method to induce a greater homogeneity in the oxide networks has been demonstrated in the case of mullite formation from silicon and aluminum alkoxides.

Similarly, solutions containing each oxide constituent of the superconductor can be separately prepared in a soluble and polymerizable form by limited water hydrolysis as described for $TiO_2$ and ZrO systems. Desired superconductive compositions can be prepared by mixing and reacting these solutions to provide homogeneity at ambient temperature and precise compositions. Three important considerations in the method of the present invention are dilution of the alkoxide solution, addition to acid to aid dissolution, and gradual addition of water initially.

Metal bonds with (OR) groups may be readily broken by the action of water as shown by the hydrolysis reaction:

$$(1)\ M_1(OR)_{z_1} + H_2O \rightarrow \underset{\substack{|\\ OH}}{M_1}(OR)_{z_1-1} + ROH$$

This hydrolysis reaction is normally carried out in a common solvent for water and metal alkoxides, e.g., alcohols.

Once sufficient hydroxyl bonds have been created, condensation polymerization to form oxide networks occurs by the reaction of these hydroxyl bonds with each other and with alkoxy bonds, as shown by the condensation reactions:

$$(2)\quad \underset{\substack{|\\ OH}}{M_1}(OR)_{z_1-1} + M_2(OR')_{z_2} \rightarrow \underset{\substack{|\\ O\\ |\\ M_2(OR')_{z_2-1}}}{M_1}(OR)_{z_1-1} + ROH$$

$$(3)\quad \underset{\substack{|\\ OH}}{M_1}(OR)_{z_1-1} + \underset{\substack{|\\ OH}}{M_2}(OR')_{z_2-1} \rightarrow \underset{\substack{|\\ O\\ |\\ M_2(OR')_{z_2-1}}}{M_1}(OR)_{z_1-1} + H_2O$$

Ultimately, these reactions will result in the inclusion of all metal elements $M_1$, $M_2$, $M_3$, etc. in the oxide network.

The course of these network forming reactions is strongly affected by chemical encounter rates where the average diffusion distances, catalysts, temperatures, water/alkoxide ratios, etc. play important roles in

shaping the polymer structure and establishing the molecular size and distribution. As the polymer is extended by the condensation reactions, the number of bridging oxygens increases at the expense of terminatal (OR) and (OH) groups. The chemical make-up of the intermediate polymers, $M_zO_{2-\frac{1}{2}(x+y)}(OH)_x(OR)_y$ changes continuously; thus, its equivalent oxide content can be anywhere up to about 95% by weight.

Once the metal alkoxides have undergone these reactions and clear polymer solutions have been formed, the composition may be fully hydrolyzed by the addition of water, converting the alkoxy groups to hydroxyl groups without precipitation of insoluble metal hydroxides. These solutions may then be heated, treated with oxidizing agents such as hydrogen peroxide or ozone, or the pH may be adjusted to affect the coordination or valence state of the metals. The solution may also be concentrated or diluted with either water, alcohol or other suitable solvent to a suitable concentration for application of a coating. Using a combination of lanthanum, strontium and copper alkoxides in the appropriate ratio provides a composition which may exhibit superconducting properties, e.g. $LaSr_2Cu_3O_{9-y}$. Using a combination of yttrium, barium and copper alkoxides in the appropriate proportions yields a composition of the known superconductor $YBa_2Cu_3O_{9-y}$ wherein y is between 1.8 and 2.5, preferably about 2.1.

Polymer solutions of La-Cu-O doped with alkaline earth oxides are brilliant blue whereas those of Y-Cu-O are green. These solutions deposit optically clear thin films, the thicknesses of which depend on the concentration of the solution and method of application. The solutions can also be concentrated and impregnated into porous materials. After the complete removal of the liquid portion, the remaining solid contains 40 to 50 percent equivalent oxide. At this stage, the compositions are highly pliable thermoplastic polymers. Upon heating to 80-120°C they attain the consistency of tar and can be similarly applied.

These compositions are converted to an oxide state upon heating to 400-500°C. The oxide can be crystallized upon further heating, e.g. at 600-1000°C. Thus, these precursor polymers go through at least four stages of form and structure: clear liquid, pliable thermoplastic polymer, amorphous solid and crystalline ceramic oxide. Furthermore, significant molecular and structural modifications can be introduced into the inorganic network structures by variations of the condensation reactions. For example, as the rate of hydrolysis can be slowed as discussed, it can also be increased. Polymer topology of thin films can be induced on the entire material. These and other variations present exciting possibilities for scientific investigation and isolating various parameters that contribute to superconductivity.

In summary, the present invention provides superconducting ceramic oxide precursor compositions in a clear liquid form by room temperature chemical reactions using organic compounds of the metal elements in superconductive oxide compositions, particularly the metal alkoxides and those compounds that condense to an oxide network at ambient temperature. Dissolving such compounds initially in a water-free solvent, e.g. alcohols, and aiding the dissolution with acids, e.g. acetic acid ($CH_3COOH$), produces a clear dilute molecular level mixture. Introducing water into the clear dilute solution in a manner to prevent self-condensation requires approximately one mole of water per mole of total alkoxides in a very dilute form, e.g. water diluted in alcohol or hydrolysis by humidity, and then introducing a large amount of water after a homogeneous oxide network is formed among the elements and self-condensation cannot occur any further. Concentrating such a solution to a desired level, e.g. 1 to 5 percent equivalent oxide, may be done for coating on substrates, e.g. wire, devices, of form impregnating porous substrates. Controlling or modifying the oxidation state of copper by use of acids, bases, $H_2O_2$, heat, pH, ozone, etc. in these solutions may be useful to enhance superconductivity. If desired, condensing such solutions to a solid state by evaporation or removing the liquid by dialysis produces thermoplastic polymers which soften between 60-120°C to a tar-like consistency which can be applied on substrates. Finally, calcining and annealing such coatings, impregnated ceramics or bulk materials in oxygen produces superconductive ceramic oxide compositions. The method of the present invention provides thin coatings, from several nanometers to microns, for devices, wires, etc., and impregnation of microporous or nanoporous ceramic or metal substrates, and avoids excessive high temperature treatments which are detrimental for superconductivity but are required to attain homogeneity in conventional ceramic processes.

The present invention will be further understood from the description of specific examples which follow.

EXAMPLE I

In order to make the superconductive composition $LaBa_2Cu_3O_{9-y}$, wherein y represents oxygen deficiency in a perovskite structure, a stoichiometric ratio of metal elements is combined from their alkoxides as follows:

| Moles | Weight (Grams) | Reactant | Formula |
|---|---|---|---|
| .01 | 3.16 | Lanthanum isopropoxide | $La(OC_3H_7)^i{}_3$ |
| .02 | 4.11 | Strontium isopropoxide | $Sr(OC_3H_7)^i{}_3$ |
| .03 | 4.16 | Copper ethoxide | $Cu(OC_2H_5)_2$ |

The powders are dispersed in 1000 millimeters of dry ethyl alcohol. Vigorous mixing yields a cloudy blue slurry. Addition of 10 grams of acetic acid, $CH_3(OOH)$, produces a clear blue solution.

One gram of water diluted in 100 millimeters of ethyl alcohol is slowly added into the above clear solution with vigorous stirring. After 10 minutes, 100 grams water is added, and no precipitation occurs. Then the solution is concentrated to 100 millimeters, containing approximately 5 percent equivalent oxide by weight, remaining clear.

An 1/8 inch platinum grid is dipped into this solution. A thin transparent film is formed in the opening. The film is fired to 500°C. Transmission electron spectroscopy this film shows that the film incorporates La, Ba, and Cu in the stoichiometric ratio required for superconductivity of the ceramic oxide.

EXAMPLE II

The well-known superconductive composition $YBa_2Cu_3O_{9-y}$ is prepared from the following organometallic components:

| Moles | Weight (Grams) | Reactant | Formula |
|---|---|---|---|
| .01 | 2.16 | Yttrium isopropoxide | $Y(OC_3H_7)^i{}_3$ |
| .02 | 4.55 | Barium ethoxide | $Ba(OC_2H_5)_2$ |
| .03 | 4.16 | Copper ethoxide | $Cu(OC_2H_5)_2$ |

The powders are introduced to 500 millimeters of dry ethyl alcohol, and 10 grams of acetic acid is added. The resulting slurry remains cloudy until another 500 millimeters of ethyl alcohol containing one gram of $H_2O$ is added. The slurry turns to a clear green solution. After 20 minutes mixing, 100 millimeters $H_2O$ is added. The solution contains 6.13 grams of oxide. The solution is concentrated to 200 millimeters containing approximately 3 percent equivalent $YBa_2Cu_3O_{9-y}$, wherein y represents oxygen deficiency, in a polymerized form. This solution deposits a superconductor precursor coating on a substrate, which is heated in oxygen above 500°C to form the ceramic oxide $YBa_2Cu_3O_{9-y}$ wherein y represents the oxygen deficiency and is preferably about 2.1.

EXAMPLE III

The superconductive composition $YBa_2Cu_3O_{9-y}$ is prepared from the following:

| Moles | Weight (Grams) | Reactants | Formula |
|---|---|---|---|
| .01 | 1.82 | Yttrium ethoxide | $Y(OCH_3)$ |
| .02 | 3.79 | Barium hydroxide | $Ba(OH)_2 \cdot H_2O$ |
| .03 | 4.16 | Copper ethoxide | $Cu(OC_2H_5)_2$ |

These materials are placed in 1000 millimeters dry ethyl alcohol and mixed vigorously. 10 grams of acetic acid is added, and the composition is stirred overnight. The slurry is cloudy, with some undissolved powder remaining. When water is added, the slurry turns into a clear blue solution. Addition of $H_2O_2$ to this solution causes it to turn black, indicating formation of $Cu^{+2}$ in the oxide form. Heating the black slurry produces a colorless clear liquid, and aging at room temperature causes it to turn clear green, indicating that the oxidation state of copper can be readily monitored in these solutions.

EXAMPLE IV

The superconductive composition $YBa_2Cu_3O_{9-y}$ is prepared from the following:

| Moles | Weight (Grams) | Reactant | Formula |
|---|---|---|---|
| .01 | 1.82 | Yttrium methoxide | $Y(OCH_3)_3$ |
| .02 | 3.79 | Barium acetate | $Ba(C_2H_3O_2)_2$ |
| .03 | 4.16 | Copper ethoxide | $Cu(OC_2H_5)_2$ |

These materials are placed in 1000 millimeters dry ethyl alcohol and mixed vigorously. 10 grams of acetic acid is added, and the composition is stirred overnight. The slurry remains cloudy with some undissolved powder remaining. When water is added, the slurry turns into a clear blue solution. Concentration of this solution produces a blue thermoplastic polymer.

EXAMPLE V

The superconductive composition $YBa_2Cu_3O_{9-y}$ is prepared from the following:

| Moles | Weight (Grams) | Reactants | Formula |
|---|---|---|---|
| .01 | 1.82 | Yttrium ethoxide | $Y(OCH_3)_3$ |
| .02 | 3.79 | Barium acetate | $Ba(NO_3)_2$ |
| .03 | 4.16 | Copper ethoxide | $Cu(OC_2H_5)_2$ |

These materials are placed in 1000 millimeters dry ethyl alcohol and mixed vigorously. 10 grams of acetic

acid is added, and the composition is stirred overnight. The slurry remains cloudy, with some undissolved powder remaining. When water is added, the slurry turns into a clear blue solution. The solution is concentrated to 3 percent equivalent oxide and dip-coated onto a glass substrate.

EXAMPLE VI

An alumina disc 1 centimeter in diameter and 1 millimeter thick composed of 64 percent porous $Al_2O_3$ is immersed in a solution as produced in Example II. The solution is then concentrated to nearly its gel state while the porous alumina disc remains in it. The impregnated alumina disc is placed in an oven and heat treated to 900°C. Electron microscopy indicates that the superconductive composition $YBa_2Cu_3O_{9-y}$ is deposited continuously within the interstices of the alumina matrix. The $YBa_2Cu_3O_{9-y}$ should produce superconductivity while the matrix material provides mechanical support.

The above examples are offered to illustrate the present invention. Various alkoxides of any metal elements in superconductive oxide formulations may be employed in accordance with the present invention in a wide range of proportions with various other organometallic reactants in different combinations and proportions to obtain specific mixed metal oxide compositions with superconducting properties. Other organometallic components such as acetates may also be used, as well as some amount of inorganic compounds such as nitrates. The ceramic oxide compositions may comprise some additional element such as fluorine. Additives may be included in superconducting compositions of the present invention, which may be prepared in a variety of alcohols or other organic solvents. The scope of the present invention is defined by the following claims.

## Claims

1. A composition of matter comprising the polymerization reaction solution of at least two metal alkoxides of the general formula $M(OR)_z$ wherein M is a metal which forms hydrolyzable alkoxides, z is the valence of M, and R is a low molecular weight organic radical, wherein the metal oxide reaction product is a superconducting ceramic oxide formulation.

2. A composition of claim 1, wherein the composition is a thermoplastic polymer composition and the ceramic oxide formed by thermal treatment thereof is a superconductive formulation.

3. A composition according to claims 1 or 2, wherein R is selected from the group consisting of alkyl, vinyl, alkoxyalkyl and aryl.

4. A composition according to claim 3, wherein R is selected from the group consisting of methyl, ethyl, propyl and butyl.

5. A composition according to claims 1 or 2, wherein said metal is selected from the group consisting of yttrium, barium, bismuth, lead, lanthanum, strontium, copper and mixtures thereof.

6. A composition according to claim 5, wherein said metal alkoxides comprise a mixture of lanthanum, strontium and copper alkoxides.

7. A composition according to claim 6, wherein said metal alkoxides comprise lanthanum isopropoxide, strontium isopropoxide and copper ethoxide.

8. A composition according to claim 7, wherein said metal alkoxide comprise lanthanum, strontium and copper is a molar ratio of 1:2:3.

9. A composition according to claim 5, wherein said metal alkoxides comprise a mixture of yttrium, barium and copper alkoxides.

10. A composition according to claim 9, wherein said metal alkoxides comprise yttrium isopropoxide, barium ethoxide and copper ethoxide.

11. A composition according to claim 10, wherein said metal alkoxides comprise yttrium, barium and copper in a molar ratio of 1:2:3.

12. A method of making superconducting mixed metal oxide composition comprising the steps of:

a. dispersing a mixture of metal alkoxides comprising copper and at least two metals from the group consisting of transition metals and rare earth elements in an organic solvent;

b. acidifying said mixture to form a clear solution;

c. partially hydrolyzing said alkoxides;

d. reacting said partially hydrolyzed alkoxides to form metal-oxygen-metal bonds;

e. further hydrolyzing and condensing the composition to form a metal oxide polymer; and

f. thermally treating the polymer to form a superconductive ceramic oxide composition.

13. A method according to claim 12, wherein the oxidation state of copper is modified by treatment with an agent selected from the group consisting of acids, bases, oxidizing agents and heat.

14. A method according to claim 12, wherein the step of partially hydrolyzing said mixture is carried out in anhydrous ethanol.

15. A method according to claim 12, wherein said mixture of metal alkoxides comprises a mixture of lanthanum, strontium and copper alkoxides.

16. A method according to claim 15, wherein said metal alkoxides comprise lanthanum isopropoxide, strontium isopropoxide and copper ethoxide.

17. A method according to claim 16, wherein said metal oxides comprise lanthanum, strontium and copper in a molar ratio of 1:2:3.

18. A method according to claim 15, wherein said metal alkoxides comprise a mixture of yttrium, barium and copper alkoxides.

19. A method according to claim 12, wherein said metal alkoxides comprise yttrium isopropoxide, barium isopropoxide and copper ethoxide.

20. A method according to claim 12, wherein said metal alkoxides comprise yttrium, barium and copper in a molar ratio of 1:2:3.

21. A method according to claim 20, which produces $YBa_2Cu_3O_{9-y}$ wherein y represents an oxygen deficiency.

22. A coated article comprising:

a. a substrate; and

b. deposited on a surface of said substrate a film-forming solution of metal alkoxides of the general formula $M(OR)_2$ wherein M is a metal which forms hydrolyzable alkoxides, z is the valence of M and R is a low molecular weight organic radical, and wherein the ceramic oxide formed by the thermal treatment thereof is a superconductive formulation.

23. An article of manufacture comprising:

a. a porous substrate; and

b. deposited in the interstices of said substrate a solution of metal alkoxides of the general formula $M(OR)_z$ wherein M is a metal which forms hydrolyzable alkoxides, z is the valence of M and R is a low molecular weight organic radical, and wherein the ceramic oxide formed by the thermal treatment thereof is a superconductive formulation.

24. An article according to claims 22 or 23, wherein R is selected from the group consisting of alkyl, vinyl, alkoxyalkyl and aryl.

25. An article according to claim 24, wherein R is selected from the group consisting of methyl, ethyl, propyl and butyl.

26. An article according to claims 22 or 23, wherein said metal is selected from the group consisting of yttrium, barium, bismuth, lead, lanthanum, strontium, copper and mixtures thereof.

27. An article according to claim 26, wherein said metal alkoxides comprise a mixture of lanthanum, strontium and copper alkoxides.

28. An article according to claim 27, wherein said metal alkoxides comprise lanthanum isopropoxide, strontium isopropoxide and copper ethoxide.

29. An article according to claim 28, wherein said metal alkoxides comprise lanthanum, strontium and copper is a molar ratio of 1:2:3.

30. An article according to claim 26, wherein said metal alkoxides comprise a mixture of yttrium, barium and copper alkoxides.

31. An article according to claim 30, wherein said metal alkoxides comprise yttrium isopropoxide, barium ethoxide and copper ethoxide.

32. An article according to claim 31, wherein said metal alkoxides comprise yttrium, barium and copper in a molar ratio of 1:2:3.